**Europäisches Patentamt**

**European Patent Office**

**Office européen des brevets**

(19)

(11) Veröffentlichungsnummer: **0 188 228**
**B1**

(12) **EUROPÄISCHE PATENTSCHRIFT**

(45) Veröffentlichungstag der Patentschrift: **27.06.90**

(51) Int. Cl.⁵: **G 03 F 3/10**

(21) Anmeldenummer: **86100215.2**

(22) Anmeldetag: **09.01.86**

(54) **Farbprüffolie für das Overlay-Verfahren.**

(30) Priorität: **14.01.85 US 691313**

(43) Veröffentlichungstag der Anmeldung:
**23.07.86 Patentblatt 86/30**

(45) Bekanntmachung des Hinweises auf die
Patenterteilung:
**27.06.90 Patentblatt 90/26**

(84) Benannte Vertragsstaaten:
**DE GB**

(56) Entgegenhaltungen:
**GB-A-1 496 967**
**GB-A-2 124 105**
**US-A-2 481 770**
**US-A-3 356 523**
**US-A-4 262 071**
**US-A-4 333 983**

**RESEARCH DISCLOSURE, Nr. 220, August 1982,
Seite 280, Nr. 22005, Havant Hampshire, GB;
"Protective overcoat for overlay proofing
systems"**

(73) Patentinhaber: **HOECHST CELANESE
CORPORATION**
**Route 202-206 North**
**Somerville, N.J. 08876 (US)**

(72) Erfinder: **Barton, Oliver A.**
**49 Afton Drive**
**Florham Park New Jersey 07932 (US)**

(74) Vertreter: **Euler, Kurt Emil, Dr. et al**
**KALLE Niederlassung der Hoechst AG**
**Rheingaustrasse 190 Postfach 3540**
**D-6200 Wiesbaden 1 (DE)**

(56) References cited:
**JOURNAL FÜR
SIGNALAUFZEICHNUNGSMATERIALIEN, Band
9, Nr. 5, 1981, Seiten 357-365, Akademie-Verlag,
Berlin, DD; M. SCHARF et al.:
"Modellbetrachtungen zur Vermeidung des
Reflexionslichthofes von streuenden und
nichtstreuenden photographischen Schichten"**

**Beschreibung**

Die vorliegende Erfindung betrifft eine Overlay-Farbprüffolie mit einer Trägerfolie aus Polyester und einer gefärbten lichtempfindlichen Schicht. Beim Overlay-Farbprüfverfahren für den Mehrfarbendruck werden im allgemeinen Teilfarbenbilder in mindestens vier Farben angefertigt, so daß ein Satz Farbauszüge vor der Verwendung zur Herstellung von MehrfarbenDruckplatten korrigiert und die später beim Drucken erhaltene Farbqualität beurteilt werden kann. Das Prüfbild muß ein getreues Abbild des gewünschten Druckbildes sein und soll den Tonwert der Farben weder erhöht noch herabgesetzt wiedergeben. Die visuelle Farbprüfung soll folgendes aufzeigen:

1. Fehler im Negativ,

2. die beste Farbwiedergabe, die beim Drucken in der Druckmaschine von dem Material zu erwarten ist,

3. die genaue Gradation aller Farbtöne und ob die Grautöne neutral sind,

4. die eventuelle Notwendigkeit zur Abschwächung einer der Farben und/oder Hinweise zur Änderung der Filmvorlagen vor der Herstellung der Druckplatten.

Bisher hat man zumeist Farbprüfungen für den Mehrfarbendruck mit einer Andruckmaschine vorgenommen, wobei alle auch beim tatsächlichn Mehrfarbendruck notwendigen Schritte unternommen werden müssen. Ein solches herkömmliches Verfahren ist jedoch kostspielig und zeitaufwendig.

Daneben werden auch photographische Verfahren angewendet. Das normale photographische Farbprüfverfahren ist das Overlay-Verfahren.

Beim Farbprüfen nach dem Overlay-Verfahren wird auf jeweils einem transparenten Kunststoffträger von jedem Farbauszug für sich ein Teilfarbenbild hergestellt, indem man eine lichtempfindliche Lösung in der entsprechenden Farbe aufbringt, diese trocknet und die erhaltene Schicht belichtet und entwickelt. Zur Herstellung eines Farbprüfsatzes werden dann mehrere solcher mit Teilfarbenbildern versehener Träger übereinandergelegt. Das Overlay-Verfahren hat den Nachteil, daß die übereinanderliegenden Kunststoffträger durch ihre Lichtabsorption bzw. -reflexion dazu neigen, das Mehrfarbenbild grauer erscheinen zu lassen, so daß der Eindruck, den man von dem so angefertigten Farbprüfsatz erhält, sich sehr stark von den Drucken unterscheidet, die man mit einer Druck- bzw. Andruckmaschine erzielt. Der Hauptvorteil dieses Verfahrens besteht darin, daß es schnell ist und durch passergenaues Kombinieren von jeweils zwei oder drei Teilfarbenbildern zur Prüfung von Korrekturmaßnahmen dienen kann.

Wie eingangs erwähnt, besteht die für die Farbprüfung geeignete normale Farbprüffolie in ihrer einfachsten Form aus einer transparenten Trägerfolie, die einseitig mit einem einen Farbstoff enthaltenden lichtempfindlichen Gemisch beschichtet ist. Als lichtempfindliches Gemisch wird bei negativ arbeitenden Materialien allgemein eine Diazoniumverbindung allein oder in Kombination mit einem Harz als Bindemittel verwendet, und diese Masse wird durch Belichten mit aktinischer Strahlung gehärtet. Nach dem Entwickeln bleiben die vom Licht getroffenen Bereiche der durch eine Negativvorlage belichteten Beschichtung als Bild auf der Trägerfolie zurück.

Aufgabe der Erfindung war es, eine Farbprüffolie und ein Farbprüfverfahren vorzuschlagen, die Hintergrundbereiche mit geringerem Grauschleier ergeben.

Gegenstand der Erfindung ist eine Farbprüffolie für das Overlay-Verfahren aus einer im wesentlichen transparenten Trägerfolie aus Polyester, die auf mindestens einer Seite eine lichtempflindliche Schicht aus einem harzartigen Bindemittel, einer lichtempfindlichen Substanz und einem Farbstoff oder einem Farbpigment trägt.

Die erfindungsgemäße Farbprüffolie ist dadurch gekennzeichnet, daß die Polyesterfolie auf mindestens einer Seite eine nicht lichtempfindliche Unterschicht aus einem vernetzten Copolymeren von Methylmethacrylat und Methacrylsäure mit einem Brechungsindex von weniger als 1,6 trägt.

Erfindungsgemäß wird ferner ein Farbprüfverfahren vorgeschlagen, bei dem von einem Mehrfarbenbild Farbauszüge hergestellt, von den Farbauszügen Teilfarbenbilder in den Grundfarben des Mehrfarbendrucks durch Kopieren auf Farbprüffolien, die eine transparente Polyesterfolie als Schichtträger und eine lichtempfindliche Schicht aus einer lichtempfindlichen Substanz, einem harzartigen Bindemittel und einem Farbstoff oder einem Farbpigment aufweisen, hergestellt und zur Gewinnung eines Mehrfarben-Prüfbilds passergenau übereinandergelegt werden.

Das erfindungsgemäße Verfahren ist dadurch gekennzeichnet, daß die Polyesterfolie auf mindestens einer Seite eine nicht lichtempfindliche Unterschicht aus einem vernetzten Copolymeren von Methylmethacrylat und Methacrylsäure mit einem Brechungsindex von weniger als 1,6 trägt.

Die erfindungsgemäße Farbprüffolie hat eine Polyesterträgerfolie mit wesentlich verbesserter Transparenz und Klarheit. Es wurde allgemein gefunden, daß eine geeignete reflexmindernde Beschichtung für Polyesterfolie transparent sein und einen Brechungsindex n haben soll, der geringer ist als der Brechungsindex der Polyesterfolie selbst (n = 1,6). Sehr vereinfacht kann man den Mechanismus, der zu diesem Phänomen führt, so erklären, daß das Licht, das normalerweise von einer Oberfläche der Folie zur anderen reflektiert würde, nun die Grenzfläche mit der geringeren Brechungsindexdifferenz ungehindert durchstrahlen kann und so zu dem Vorteil einer verbesserten Folientransparenz führt.

Als flexible Polyesterfolie kann jede beliebige flexible Folie genommen werden, die aus einem beliebigen thermoplastischen filmbildenden Polyester besteht, der durch Kondensation einer Dicarbonsäure oder eines niedermolekularen Dialkylesters dieser Säure mit einem Diol erhalten worden ist. Zu den Dicarbonsäuren bzw. deren niedermolekularen Dialkylestern, die für die Herstellung einer flexiblen Polyesterträgerfolie geeignet sind, zählen Terephthalsäure, Isophthalsäure, Phthalsäure, 2,5-, 2,6- und 2,7-Naphthalindicarbonsäure, Bernsteinsäure, Sebacinsäure, Adipinsäure, Azelainsäure, Dibenzoesäure, Hexahydrophthalsäuren und Bis-(4-carboxyphenoxy)ethan. Mindestens eine dieser Säuren und deren niedermolekulare Dialkylester werden mit mindestens einem Diol, z.B. Ethylenglykol, Diethylenglykol, 1,3-Propandiol, 1,4-Butandiol, Neopentylglykol oder Cyclohexan-1,4-dimethanol, umgesetzt. Da mindestens ein Diester mit mehr als einem Diol umgesetzt werden kann, beschränkt sich die erfindungsgemäße Polyesterfolie nicht auf Homopolyester, sondern umfaßt auch Mischpolyester.

Von den filmbildenden Polyestern werden im Rahmen dieser Erfindung diejenigen bevorzugt, die zumindest einen größeren Anteil Polyethylenterephthalat enthalten, wobei Polyethylenterephthalatfolie insbesondere bevorzugt ist. Die Polyethylenterephthalatfolie wird aus einem Polymeren hergestellt, das man durch Polymerisation von Bis-(2-hydroxyethyl)-terephthalat erhalten hat. Das Bis-(2-hydroxyethyl)-terephthalat selbst wird als Zwischenprodukt nach einem von zwei verschiedenen Verfahren hergestellt. Das eine Verfahren zur Herstellung von Bis-(2-hydroxyethyl)-terephthalat besteht in der direkten Veresterung von Terephthalsäure mit Ethylenglykol, wie es z.B. in der US-A 3 050 533 beschrieben ist. Bei diesem Verfahren entsteht als Nebenprodukt der Reaktion Wasser, das vom Reaktionsprodukt abdestilliert wird. Bei dem zweiten Verfahren wird Bis-(2-hydroxyethyl)-terephthalat durch Umesterung eines Dialkylesters der Terephthalsäure, vorzugsweise Dimethylterephthalat, mit Ethylenglykol hergestellt. Dabei reagieren bevorzugt zwei mol Ethylenglykol mit einem mol Dialkylterephthalat. Insbesondere werden mehr als zwei mol Ethylenglykol pro mol Dialkylterephthalat genommen, da die Umesterungsreaktion unter diesen Bedingungen rascher und vollständiger abläuft. Die Umesterungsreaktion wird bei hoher Temperatur durchgeführt. Die Temperatur kann zum Beispiel zwischen der Siedetemperatur des Reaktionsgemischs und 250°C liegen. Die Reaktion kann bei Normal-, Unter- oder Überdruck ablaufen. Als Nebenprodukt der Umesterungsreaktion erhält man ein Alkanol, zum Beispiel Methanol bei Verwendung von Dimethylterephthalat. Das Alkanol wird aus dem Reaktionsprodukt entfernt. Nach Belieben können zur Steigerung der Reaktionsgeschwindigkeit bekannte Katalysatoren bei der Umesterung eingesetzt werden.

Das so hergestellte Bis-(2-hydroxyethyl)terephthalat kann durch Erhitzen auf eine Temperatur oberhalb des Siedepunkts des Ethylenglykols oder des Reaktonsgemischs bis zu etwa 325°C, unter Bedingungen, die das Abtrennen des Glykols oder Wassers begünstigen, zu Polyethylenterephthalat umgesetzt werden. Während des Erhitzens wird der Druck vermindert, so daß das überschüssige Glykol oder Wasser rasch abdestilliert. Das fertige Polyethylenterephthalat kann, gemessen in Orthochlorphenol bei 25°C, eine Grenzviskositätszahl von mehr als 0,3 dl/g haben. Vorzugsweise liegt die Grenzviskositätszahl des Polymeren bei 0,4 bis 1,0 dl/g, besonders bevorzugt bei etwa 0,5 bis 0,7 dl/g.

In einer bevorzugten Ausführung wird aus dem filmbildenden Polyester eine Schmelze hergestellt, die dann auf eine polierte, rotierende Gießtrommel extrudiert wird, wo sich eine flexible Folie aus dem Polymeren ausbildet. Anschließend wird die Folie axial gestreckt, und zwar bei einer Richtung, d.h. entweder in Extrusionsrichtung (längs) oder senkrecht zur Extrusionsrichtung (quer), und bei einer biaxial orientierten Folie in beiden Richtungen. Um der Folie Festigkeit und Zähigkeit zu verleihen, kann die extrudierte Folie etwa auf das 3- bis 5-fache ihrer ursprünglichen Abmessungen in einer oder beiden Richtungen gestreckt werden. Der Verstreckungsgrad liegt vorzugsweise etwa zwischen dem 3,2- und 4,2- fachen der ursprünglichen Abmessungen. Während der Streckschritte liegen die Temperaturen im Bereich zwischen Glasübergangstemperatur und der Temperatur, bei der das Polymere weich wird und schmilzt. Es ist wichtig, daß die Strecktemmperatur oberhalb der Glasübergangstemperatur der Folie liegt. Anschließend wird die Folie zur Kristallisation auf eine Temperatur zwischen 130 und 240°C, vorzugsweise von 150 bis 180°C erhitzt, wobei sie in Querrichtung fixiert wird, jedoch ohne sie dabei zu strecken. Die Kristallisation ist normalerweise nach einer Behandlungsdauer von etwa 5 s oder mehr abgeschlossen. Die Folie wird dann im wesentlichen bis auf Raumtemperatur abgekühlt. Die so hergestellte Folie kann eine Dicke von 12 bis 750 µm, vorzugsweise von 25 bis 220 µm, insbesondere von 75 bis 180 µm aufweisen.

Anschließend wird auf die polyesterfolie eine erste, nicht lichtempfindliche Beschichtungsmasse mit einem Brechungsindex unter 1,6 aufgebracht, die im wesentlichen aus einem Copolymeren von Methylmethacrylat und Methacrylsäure besteht. Der Begriff "besteht im wesentlichen aus" soll bedeuten, daß die nicht lichtempfindliche Masse keine Stoffe enthält, durch deren Anwesenheit die Fähigkeit der Beschichtung zur Transparenzsteigerung von Polyesterfolie stark beeinträchtigt würde. Die Komponenten des Copolymeren können in ungefähr gleichen Mengen in dem Copolymeren enthalten sein, vorzugsweise besteht das Copolymere jedoch zum größeren Teil aus Methylmethacrylateinheiten. Besonders bevorzugt enthält das Copolymere 80 bis 95% Methylmethacrylat- und 5 bis 20% Methacrylsäureeinheiten.

Das erfindungsgemäße Methylmethacrylat/Methacrylsäure-Copolymere kann nach jedem beliebigen in der Polymerchemie bekannten Verfahren hergestellt werden, durch Lösungs-, Dispersions- oder Emulsionspolymerisation, wie es in den US-A 4 465 572 und 4 430 419 beschrieben ist. Vorzugsweise wird das Copolymere durch Lösungspolymerisation hergestellt, weil dabei die Beschichtungslösung vor dem Beschichten nicht mehr filtriert zu werden braucht.

Die erste Beschichtungsmasse kann gegebenenfalls ein Härtungsmittel zum Härten des Copolymeren enthalten. Das Härten des Copolymeren hat zwar keinen wesentlichen Einfluß auf die Verbesserung der Transparenz der Polyesterträgerfolie, es erhöht jedoch die Beständigkeit der ersten Beschichtung gegenüber dem Lösemittelsystem eines auf diese Beschichtung aufgebrachten lichtempfindlichen Gemischs. Bevorzugte Härtemittel sind polyfunktionelle Aziridine. Spezielle Härtemittel, die bei der

3

praktischen Durchführung der Erfindung gut verwendbar sind, sind zum Beispiel Trimethylolpropan-tris[ß-(N-aziridinyl)propionat] (Handelsprodukt XAMA-2 der Cordova Chemical Company, USA), sowie Pentaerythrittris-[ß-(N-aziridinyl)propionat] (Handelsprodukt XAMA-7 des gleichen Herstellers). Falls gewünscht, kann der ersten Beschichtung auch ein Härtungsbeschleuniger, z.B. Triethanolamin, zugesetzt werden.

Die erste Beschichtung kann als Lösung oder Dispersion der Beschichtungskomponenten in einem geeigneten Lösemittel auf die Polyesterträgerfolie aufgebracht werden. Als Lösemittel eignen sich z.B. Dimethylsulfoxid, Dimethylformamid, Tetrahydrofuran, Glykolether, z.B. Propylenglykolmonomethylether, Ethylenglykolmonomethylether und Ethylenglykolmonoethylether; Ester, z B. Ethylacetat, Butylacetat und Amylacetat; Ketone, z.B. Methylethylketon, Cyclohexanon und Diacetonalkohol sowie deren Gemische. Das Beschichten kann nach einem bekannten Verfahren erfolgen, zum Beispiel durch Walzenbeschichtung, Schlitzgießerbeschichtung, Aufsprühen, Gravurbeschichtung oder Beschichtung durch Kiss-Coating. Bevorzugt wird die erste Beschichtung nach einem Kiss-Coating-Verfahren auf die Polyesterfolie aufgebracht. Die Lösemittel können anschließend nach bekannten Verfahren vertrieben werden, wobei aber ein gewisser Lösemittelrest zurückbleiben kann.

Gemäß einer bevorzugten Ausführung wird die erste Beschichtung zu einem Schichtgewicht von mindestens 0,5 g/m² auf die Folie aufgebracht. Die obere Grenze für das Schichtgewicht wird durch das Gewicht gebildet, oberhalb dessen die Beschichtung nicht mehr elastisch ist und bei der Handhabung die Tendenz zum Reißen zeigt. Diese Grenze liegt im allgemeinen bei 7 g/m². Die erste Beschichtung hat bevorzugt ein Beschichtungsgewicht von 1 bis 6, insbesondere von 2 bis 5 g/m². Ferner wird die erste Beschichtung vorzugsweise auf beide Seiten der Polyesterfolie aufgebracht, da die Transparenz einer beidseitig beschichteten Folge gegenüber einer nur einseitig beschichteten Folie verbessert ist, wobei allerdings jede dieser Folien im Vergleich mit unbeschichteter Folie eine erhebliche Verbesserung zeigt.

Auf die mit der ersten Beschichtung versehene Polyesterfolie wird dann eine zweite Beschichtung aus dem oben angegeben lichtempfindlichen Gemisch aufgebracht.

Das verwendete lichtempfindliche Gemisch kann positiv oder negativ arbeiten. Als Bindemittel für negativ arbeitende Systeme sind z.B. geeignet: Celluloseester, wie Celluloseacetat, Celluloseacetatsuccinat und Celluloseacetatbutyrat; Polyvinylacetale, wie Polyvinylbutyral und Polyvinylformal; Polyamide; Copolymere von Vinylchlorid mit polaren Monomeren, z.B. mit Acrylnitril, Acryl- oder Methacrylsäure oder deren Estern und mit Vinylacetat; polymere Ester, wie z.B. Polyvinylacetat oder Copolymere von Vinylacetat mit Acrylsäure, Methacrylsäure oder deren Estern oder mit Maleinsäure oder Maleinsäureanhydrid; Copolymere von Styrol mit Säurederivaten als Comonomeren, wie Ethylacrylat, Vinylacetat und Maleinsäureanhydrid; natürliche Polymere, wie Gelatine, Casein oder Fischleim; Polyvinylalkohol; Polyacrylamide und ähnliche Polymere. In einem positiv arbeitenden System sind die als Bindemittel verwendeten Harze meistens alkalilösliche Harze, z.B. phenol-Formaldehyd-Novolake und ähnliche Harze. Das Bindemittel ist vorzugsweise ein Copolymeres von Methylmethacrylat und Methacrylsaure.

Zu den in der lichtempfindlichen Schicht enthaltenen Farbmitteln zählen die bekannten Farbstoffe und Pigmente, deren Farbtöne im wesentlichen mit den Grundfarben des Mehrfarbendrucks identisch sind, z.B. Gelb, Blaugrün, Purpur und Schwarz. Geeignete Farbmittel sind beispielsweise Grasol Echtgelb 5 FL (C.I. Solvent Yellow 27), Grasol Echtrubin 2 BL (C.I. Solvent Red 128), Viktoriareinblau FGA (C.I. Basic Blue 81), Neozapongelb GG (C.I. Solvent Yellow 79), Neozaponechtrot BE (C.I. Solvent Red 122), Sudanblau II (C.I.-Solvent Blue 35 — C.I. 6155 (S)), Victoria Cyan F6G (C.I. 42025), Rhodamin FB (C.I. 45170), Rhodamin 6 GDN Extra (C.I. 45160), Auraminkonzentrat (C.I. 41000), Ruß und ähnliche Farbmittel.

Als lichtempfindliche Substanzen können alle geeigneten bekannten lichtempfindlichn Diazoniumsalze verwendet werden. Bevorzugt werden die Diazoniumsalz-Polykon-Kondensationsprodukte, z.B. die mit Formaldehyd kondensierten Produkte, wie sie aus den US-A 2 063 631 und 2 667 415 bekannt sind und insbesondere die Mischkondensationsprodukte, die in den US-A 3 849 392, 3 867 147 und 4 436 804 beschrieben sind.

Das von diesen Diazoniumsalzen am meisten bevorzugte ist das in der US-A 3 849 392 beschriebene Kondensationsprodukt aus 3-Methoxy-diphenylamin-4-diazoniumsalz und 4,4'-Bis-methoxymethyldiphenylether.

Weitere als lichtempfindliche Substanzen gemäß dieser Erfindung geeignete Stoffe sind polymerisierbare Monomere oder Oligomere in Verbindung mit einem Photoinitiator, bei denen das für das Aufbringen auf die Folie verwendete Lösemittelsystem nicht so stark oder aggressiv ist, daß es die bereits auf der Folie befindliche nicht lichtempfindliche Schicht anlöst.

Es ist hervorzuheben, daß die erfindungsgemäß einsetzbaren lichtempfindlichen Massen bekannt sind und aufgrund ihrer Verträglichkeit und Eignung in Verbindung mit den hier beschriebenen Bindemitteln ausgewählt werden sollten.

Die lichtempfindlichen Beschichtungsgemische werden am bequemsten so auf die Trägerfolie aufgebracht, daß man eine Lösung oder Dispersion der Beschichtungsbestandteile in einem geeigneten Lösemittel herstellt, die gewünschte Menge der Lösung nach einem geeigneten Verfahren, z.B. durch Walzen-, Tauch-, Meniskus- oder Rakelbeschichtung oder durch Aufschleudern auf die Folienoberfläche aufbringt und das Lösemittel durch Trocknen aus der Beschichtung vertreibt, wobei allerdings ein gewisser Lösemittelrest zurückbleiben kann. Das lichtempfindliche Beschichtungsgemisch kann auf eine oder beide

4

Seiten der beschichteten Polyesterträgerfolie aufgebracht werden, auch wenn die nicht lichtempfindliche erste Beschichtung sich nur auf einer Seite der Polyesterfolie befindet. Geeignete Lösemittel sind z.B. Dimethylsulfoxid, Dimethylformamid, Tetrahydrofuran, Glykolether, wie Propylenglykolmonomethylether, Ethylenglykolmonomethylether und Ethylenglykolmonoethylether; Ester, wie Ethylacetat, Butylacetat und Amylacetat; Ketone, wie Methylethylketon, Cyclohexanon und Diacetonalkohol sowie deren Gemische.

Bezogen auf das Trockengewicht soll die Beschichtung im allgemeinen etwa 25 bis 75 Gew.-% Bindemittel enthalten. Ein wirksamer Farbmittelanteil liegt allgemein im Bereich von 2 bis 15 Gew.-%, und die Anteile an lichtempfindlichen Substanzen entsprechen den üblichen Mengen. Der Feststoffanteil der Beschichtungslösung richtet sich nach dem angewendeten Beschichtungsverfahren, im allgemeinen sind jedoch Lösungen mit einem Feststoffgehalt von 2 bis 20 Gew.-% ausreichend.

Vorteilhaft hat die zweite Beschichtung ein Beschichtungsgewicht von 3,5 bis 7,5 g/m². Vorzugsweise hat sie ein Gewicht von 4,0 bis 6,0 g/m².

Die so hergestellte Overlay-Farbprüffolie kann durch eine geeignete Maske oder Kontaktvorlage mit aktinischem Licht belichtet und anschließend mit einem wäßrig-alkalischen Entwickler entwickelt werden. Geeignete Entwickler können als Komponenten z.B. Mononatriumphosphat, Trinatriumphosphat und das Natriumsalz des 7-Ethyl-2-methyl-4-undecanolsulfats enthalten.

Die folgenden Beispiele zeigen, daß es zwar auch andere Beschichtungen gibt, die einen niedrigeren Brechungsindex als Polyesterfolie haben, daß aber nur mit den erfindungsgemäßen Beschichtungen erfolgreich eine Farbprüffolie mit erhöhter Transparenz hergestellt werden kann.

Beispiel 1

Auf polyesterfolien (Melinex 516), die zur leichteren Handhabung und um die Wirkungen der elektrostatischen Aufladung auszuschalten mit feinteiligem SiO₂ substriert sind, werden dünne Schichten aus verschiedenen Beschichtungsharzen aufgebracht, die jeweils einen niedrigeren Brechungsindex n als die Polyesterfolie haben, und die erhaltenen Folien werden auf Opazität, Benetzungsfähigkeit mit einer lichtempfindlichen Beschichtungslösung und Lösemittelresistenz geprüft. Die Ergebnisse sind in Tabelle 1 enthalten.

<div align="center">

### Tabelle 1

</div>

| Beschichtung | n | Bemerkungen |
|---|---|---|
| 1. Polytetrafluorethylen | 1,35 | zu opak, lichtempfindliche Beschichtung benetzt die Oberfläche nicht, Lösemittelresistenz annehmbar |
| 2. Silikon (Syl-off 294, Hersteller Dow-Corning) | 1,43 | transparent, läßt sich jedoch nicht mit lichtempfindlicher Beschichtung benetzen, Lösemittelresistenz annehmbar, wenn vernetzt |
| 3. Methylmethacrylat/Methacrylsäure-Copolymeres 85:15 (hergestellt durch Dispersionspolymerisation) | 1,49 | transparent, benetzungsfähig, Lösemittelresistenz annehmbar, wenn vernetzt |
| 4. Methylmethacrylat/Methacrylsäure-Copolymeres 95:5 (hergestellt durch Dispersionspolymerisation) | 1,49 | transparent, benetzungsfähig, Lösemittelresistenz annehmbar, wenn vernetzt |
| 5. Methylmethacrylat/Methacrylsäure-Copolymeres 85:15 (hergestellt durch Lösungspolymerisation) | 1,49 | transparent, benetzungsfähig, Lösemittelresistenz annehmbar, wenn vernetzt |

Die erfindungsgemäßen Beschichtungen (3, 4 und 5) sind die einzigen, die beim nachträglichen Beschichten mit einer lichtempfindlichen Schicht ein befriedigendes Verhalten zeigen.

EP 0 188 228 B1

### Beispiel 2

23,75 g eines durch Dispersionspolymerisation (10% Feststoffgehalt in Ethylenglykolmonomethylether) hergestellten Copolymerisats aus 85% Methylmethacrylat und 15% Methacrylsäure werden in 525 g eines Gemischs aus Ethylenglykolmonomethylether und Methylethylketon (1:1) unter mäßigem Rühren gelöst und ergeben eine klare Lösung. Dieser Lösung werden 0,5 g Triethanolamin zugegeben, und es wird weiter gerührt. Nach Hinzufügen von 1,25 g Trimethylolpropan-tris-[ß-(N-aziridinyl)propionat] wird dann noch weitere 30 Minuten gerührt, um ein vollständiges Vermischen sicherzustellen. Vor der Verwendung zum Beschichten wird die Lösung durch ein Whatman-Filterpapier Nr. 4 filtriert und anschließend zu einem Beschichtungsgewicht von 0,5 g/m² nach dem Kiss-Coating-Verfahren auf beide Seiten einer 75 µm dicken Polyesterfolie (Melinex 516) aufgebracht. Die beschichtete Folie wird dann etwa 1 Minute bei 135°C im Trockenschrank getrocknet. Die Reflexionsdichte der erhaltenen Folie wird mit einem Spektralphotometer IBM-7410 gemessen. In der Tabelle 2 sind die Ergebnisse der Prüfung aufgeführt.

### Beispiel 3

Es wird eine Beschichtungslösung wie in Beispiel 2 beschrieben hergestellt und auf beide Seiten einer 75 µm dicken polyesterfolie (Melinex 516) mit einem Beschichtungsgewicht von 1 g/m² aufgebracht. Zur Bestimmung der Transparenz der resultierenden Folie wird ihre Reflexionsdichte gemessen. Die Ergebnisse sind in Tabelle 2 angegeben.

### Beispiel 3a

Es wird eine Beschichtungslösung wie in Beispiel 3 beschrieben hergestellt und aufgetragen, wobei allerdings in diesem Beispiel die Komponenten Triethanolamin und Trimethylolpropan-tris-[ß-(N-aziridinyl)propionat] weggelassen werden, so daß sich eine ungehärtete Beschichtung ergibt. Zur Bestimmung der Transparenz der resultierenden Folie wird dann ihre Reflexionsdichte gemessen. Die Ergebnisse sind in Tabelle 2 angegeben.

### Beispiel 4

Es wird eine Beschichtungslösung wie in Beispiel 2 beschrieben hergestellt und zu einem Beschichtungsgewicht von 2 g/m² auf beide Seiten einer 75 µm dicken Polyesterfolie (Melinex 516) aufgebracht. Zur Bestimmung der Transparenz der resultierenden Folie wird dann ihre Reflexionsdichte gemessen. Die Ergebnisse sind in Tabelle 2 angegeben.

### Beispiel 4a

Es wird eine Beschichtungslösung wie in Beispiel 4 beschrieben hergestellt und aufgetragen, wobei allerdings in diesem Beispiel die Komponenten Triethanolamin und Trimethylolpropan-tris-[ß-(N-aziridinyl)propionat] weggelassen werden, so daß sich eine ungehärtete Beschichtung ergibt. Zur Bestimmung der Transparenz der resultierenden Folie wird dann ihre Reflexionsdichte gemessen. Die Ergebnisse sind in Tabelle 2 angegeben.

### Beispiel 5

Es wird eine Beschichtungslösung wie in Beispiel 2 beschrieben hergestellt und zu einem Beschichtungsgewicht von 6 g/m² auf eine 75 µm dicke Polyesterfolie (Melinex 516) aufgebracht. Zur Bestimmung der Transparenz der resultierenden Folie wird dann ihre Reflexionsdichte gemessen. Die Ergebnisse sind in Tabelle 2 angegeben.

### Beispiel 6

Es wird eine Beschichtungslösung wie in Beispiel 2 beschrieben hergestellt und zu einem Beschichtungsgewicht von 7 g/m2 auf beide Seiten einer 75 µm dicken Polyesterfolie (Melinex 516) aufgebracht. Zur Bestimmung der Transparenz der resultierenden Folie wird dann ihre Reflexionsdichte gemessen. Die Ergebnisse sind in Tabelle 2 angegeben.

### Beispiel 7

Es wird eine Beschichtungslösung wie in Beispiel 2 beschrieben hergestellt und zu einem Beschichtungsgewicht von 2 g/m² auf eine Seite einer 75 µm dicken Polyesterfolie (Melinex 516) aufgebracht. Zur Bestimmung der Transparenz der resultierenden Folie wird dann ihre Reflexionsdichte gemessen. Die Ergebnisse sind in Tabelle 2 angegeben.

### Beispiel 8

409 g eines durch übliche Lösungspolymerisation (36% Feststoffgehalt in Ethylenglykolmonomethylether) hergestellten Copolymerisats aus 85% Methylmethacrylat und 15% Methacrylsäure werden unter mäßigem Rühren in 712 g Propylenglykolmonomethylether und 446 g Methylethylketon gelöst. Dieser Lösung werden zunächst 1,5 g Triethanolamin und dann 4,27 g Trimethylolpropan-tris[ß-(N-aziridinyl)propionat] zugegeben, und es wird weitere 10 Minuten gerührt, um ein vollständiges Vermischen sicherzustellen. Die Lösung wird dann zu einem Beschichtungsgewicht von 4,3 g/m² beidseitig auf 75µm dicke Polyesterfolie, die zur Verbesserung der Klarheit mit einem Haftvermittler substriert ist, aufgebracht. Die beschichtete Folie wird dann etwa 1 Minute bei 135°C im Trockenschrank getrocknet. Die Reflexionsdichte der erhaltenen Folie wird mit einem Spektralphotometer IBM-7410 gemessen. Die Ergebnisse sind in Tabelle 2 enthalten.

EP 0 188 228 B1

## Tabelle 2

| Beispiel | Reflexions-dichte | Bemerkungen |
|---|---|---|
| unbeschich-tete Folie | 0,059 | --- |
| 2 | 0,028 | Newton'sche Ringe sichtbar |
| 3 | 0,037 | " " " |
| 3a | 0,037 | " " " |
| 4 | 0,037 | praktisch keine Newton'schen Ringe |
| 4a | 0,037 | " " " " |
| 5 | 0,038 | keine Newton'schen Ringe |
| 6 | 0,040 | Risse in der Beschichtung sichtbar |
| 7 | 0,046 | praktisch keine Newton'schen Ringe |
| 8 | 0,036 | keine Newton'schen Ringe |

Aus diesen Angaben wird ersichtlich, daß die Transparenz von Polyesterfolie durch das Aufbringen der erfindungsgemäßen Beschichtung verbessert wird. Wird nur eine Seite beschichtet, so verbessert sich die Transparenz bereits erheblich, während das Beschichten beider Seiten die größte Verbesserung ergibt.

### Beispiel 9

Zur Herstellung eines lichtempfindlichen Gemischs werden 2,7 g eines Copolymerisats aus 85% Methylmethacrylat und 15% Methacrylsäure als Bindemittel in einem Lösemittelgemisch aus 35 g Methylethylketon, 20 g Propylenglykolmonomethylether und 20 g Diacetonalkohol unter mäßigem Rühren gelöst. Dann werden die folgenden Farbstoffe unter Rühren zugesetzt: 0,4 g Calcozingelb, 0,2 g Rhodamin GDN und 0,1 g Viktoriareinblau. Während die Lösung weiter gerührt wird, werden 3,5 g des Kondensationsprodukts aus 3-Methoxydiphenylamin-4-diazoniumsulfat und 4,4′-Bismethoxymethyldiphenylether, ausgefällt als Mesitylensulfonat, und anschließend 3,0 g Hydroxypropylcellulose (Klucel MF), zugegeben. Nach Zugabe aller Komponenten wird der gesamte Ansatz 30 Minuten gerührt, um ein vollständiges Vermischen sicherzustellen.

Die Lösung wird dann mit dem Rakel zu unterschiedlichen Beschichtungsgewichten auf die in den Beispielen 3 und 4 hergestellten Folien aufgebracht. Die beschichteten Folien werden unter einer Negativvorlage belichtet und mit einem Entwickler aus Trinatriumphosphat, Mononatriumphosphat, dem Natriumsalz von 7-Ethyl-2-methyl-4-undecylsulfat und Wasser von Hand entwickelt. Zur Bestimmung der Transparenz eines klaren Abschnitts der resultierenden Folie wird dessen Reflexionsdichte gemessen. Die Ergebnisse sind in Tabelle 3 aufgeführt.

### Tabelle 3

| Folie aus Beispiel | Beschichtungs-gewicht | Reflexions-dichte |
|---|---|---|
| 3 | 4,25 $g/m^2$ | 0,036 |
| 3 | 5,05 $g/m^2$ | 0,037 |
| 4 | 5,52 $g/m^2$ | 0,037 |

Nach dem Bebildern der lichtempfindlichen Schicht wird keine wesentliche Erhöhung der Reflexionsdichte der Folien festgestellt.

### Beispiel 10

Zur Herstellung eines lichtempfindlichen Gemischs werden 210 g Methylethylketon, 94,5 g Propylenglykolmonomethylether und 140 g Diacetonalkohol unter mäßigem Rühren miteinander

9

vermischt und dann 21 g Styrol/Maleinsäurehalbester-Copolymerisat (Scripset 540) mit einem mittleren Molekulargewicht von etwa 10.000 bis 50.000 zugegeben und so lange gerührt, bis das Copolymerisat sich gelöst hat. Anschließend werden unter ständigem Rühren 1,75 g p-Toluolsulfonsäure und 10,5 g des Kondensationsprodukts aus 3-Methoxy-diphenylamin 4-diazoniumsulfat und 4,4'-Bis-methoxymethyldiphenylether, ausgefällt als Mesitylensulfonat, hinzugefügt. In einem getrennten Gefäß werden 122,5 g einer Dispersion von 41% $TiO_2$ und 9,1% Styrol/Maleinsäurehalbester-Copolymerisat (Scripset 540) in Propylenglykolmonomethylether und 42 g einer Dispersion von 6.3% Ofenruß und 11,7% Scripset 540 in Methylethylketon miteinander vermischt. Das zuerst hergestellte Gemisch wird dann der Dispersionsmischung zugesetzt, und der gesamte Ansatz wird 30 Minuten gerührt.

Dieser Ansatz wird danach zu einem Beschichtungsgewicht von 5,1 $g/m^2$ durch Meniskusbeschichten auf die in Beispiel 8 hergestellte Folie aufgebracht. Die beschichtete Folie wird durch eine Negativvorlage belichtet und mit dem in Beispiel 9 beschriebenen Entwickler von Hand entwickelt. Die Transparenz eines klaren Abschnitts der erhaltenen Folie wird gemessen, indem dessen Reflexionsdichte gemessen wird. Es ergibt sich eine Reflexionsdichte von 0,037.

Auch in diesem Fall zeigt sich nach dem Bebildern der lichtempfindlichen Schicht keine wesentliche Erhöhung der Reflexionsdichte der Folie.

## Patentansprüche

1. Farbprüffolie für das Overlay-Verfahren aus einer im wesentlichen transparenten Trägerfolie aus einem Polyester einer Dicarbonsäure mit einem Diol, die auf mindestens einer Seite eine lichtempfindliche Schicht aus einem harzartigen Bindemittel, einer lichtempfindlichen Substanz und einem Farbstoff oder einem Farbpigment trägt, dadurch gekennzeichnet, daß die Polyesterfolie auf mindestens einer Seite eine nicht lichtempfindliche Unterschicht aus einem vernetzten Copolymeren von Methylmethacrylat und Methacrylsäure mit einem Brechungsindex trägt, der kleiner als der der Polyesterfolie und kleiner als 1,6 ist.

2. Farbprüffolie nach Anspruch 1, dadurch gekennzeichnet, daß die Unterschicht aus dem Reaktionsprodukt des Copolymeren mit einem Härtungsmittel besteht.

3. Farbprüffolie nach Anspruch 1, dadurch gekennzeichnet, daß die Unterschicht aus dem Reaktionsprodukt des Copolymeren mit einem Härtungsmittel und einem Härtungsbeschleuniger besteht.

4. Farbprüffolie nach Anspruch 1, dadurch gekennzeichnet, daß das Copolymere der Unterschicht 80-95 Gew.-% Methylmethacrylat- und 5-20 Gew.-% Methacrylsäureeinheiten enthält.

5. Farbprüffolie nach Anspruch 1, dadurch gekennzeichnet, daß das harzartige Bindemittel der lichtempfindlichen Schicht freie Carboxylgruppen enthält.

6. Farbprüffolie nach Anspruch 1, dadurch gekennzeichnet, daß die lichtempfindliche Schicht ein Diazoniumsalz-Polykondensationsprodukt enthält.

7. Farbprüfverfahren, bei dem von einem Mehrfarbenbild Farbauszüge, von den Farbauszügen Teilfarbenbilder in den Grundfarben des Mehrfarbendrucks durch Kopieren auf Farbprüffolien, hergestellt und zur Gewinnung eines Mehrfarben-prüfbilds passergenau übereinandergelegt werden, dadurch gekennzeichnet, daß als Farbprüffolien Folien gemäß einem der Ansprüche 1 bis 6 eingesetzt werden.

## Revendications

1. Feuille d'épreuve en couleurs pour le procédé OVERLAY (de masque) formée d'une feuille support essentiellement transparente formée d'un polyester d'un acide dicarboxylique et d'un diol, laquelle comporte sur au moins l'une de ses faces une couche photosensible formée d'un agent liant de type résine, une substance photosensible et une substance colorante ou un pigment colorant, caractérisée en ce que la feuille de polyester comporte sur au moins l'un de ses faces une couche de base qui n'est pas photosensible formée d'un copolymère réticulé de méthacrylate de méthyle et d'acide méthacrylique ayant un indice de réfraction inférieur à celui de la feuille de poyester et inférieur à 1,6.

2. Feuille d'épreuve en couleurs selon la revendication 1, caractérisée en ce que la couche de base est constituée par le produit de réaction du copolymère avec un agent de durcissement.

3. Feuille d'épreuve en couleurs selon la revendication 1, caractérisée en ce que la couche de base est composée du produit de réaction du copolymère avec un agent de durcissement et un accélérateur de durcissement.

4. Feuille d'épreuve en couleurs selon la revendication 1, caractérisée en ce que le copolymère de la couche de base contient de 80 à 95% en poids de méthacrylate de méthyle et de 5 à 20% en poids de motifs d'acide méthacrylique.

5. Feuille d'épreuve en couleurs selon la revendication 1, caractérisée en ce que l'agent liant de type résine de la couche photosensible contient des groupes carboxy libre.

6. Feuille d'épreuve en couleurs selon la revendication 1, caractérisée en ce que la couche photosensible contient un produit de polycondensation d'un sel de diazonium.

7. Procédé d'essai de couleurs dans lequel on prépare d'abord des sélections de couleurs à partir d'une image polychrome, puis on prépare des images trichromes dans les couleurs du fond de l'impression polychrome à partir des sélections de couleur par copie sur feuilles d'épreuve en couleurs et on les superpose de manière à les faire coïncider exactement pour obtenir une image d'épreuve polychrome, caractérisé en ce qu'on utilise comme feuilles d'épreuve en couleurs des feuilles selon l'une des revendications 1 à 6.

**Claims**

1. Colour test foil for the overlay method consisting of an essentially transparent backing foil made from a polyester of a dicarboxylic acid with a diol, which carries on at least one side a photosensitive layer comprising a resinous binder, a photosensitive substance and a dye or a coloured pigment, characterized in that the polyester foil carries on at least one side a nonphotosensitive under layer made from a crosslinked copolymer of methyl methacrylate and methacrylic acid with a refractive index less than that of the polyester foil and less than 1.6.

2. Colour test foil according to Claim 1, characterized in that the underlayer consists of the reaction product of the copolymer with a curing agent.

3. Colour test foil according to Claim 1, characterized in that the underlayer consists of the reaction product of the copolymer with a curing agent and a curing accelerator.

4. Colour test foil according to Claim 1, characterized in that the copolymer of the underlayer contains 80-95% by weight of methyl methacrylate units and 5-20% by weight of methacrylic acid units.

5. Colour test foil according to Claim 1, characterized in that the resinous binder of the photosensitive layer contains free carboxyl groups.

6. Colour test foil according to Claim 1, characterized in that the photosensitive layer contains a diazonium salt polycondensation product.

7. Colour test method in which colour separations are produced from a colour image, partial colour images in the primary colours of the colour print are produced from the colour separations by copying onto colour test foils and are positioned accurately one on top of the other to give a colour test image, characterized in that, as colour test foils, foils according to one of Claims 1 to 6 are employed.